# EUROPÄISCHE PATENTSCHRIFT

(11) **EP 3 183 817 B1**
(45) Veröffentlichungstag und Bekanntmachung des Hinweises auf die Patenterteilung: **05.05.2021**
(21) Anmeldenummer: 14766890.9
(22) Anmeldetag: 22.08.2014
(51) Int. Cl.: H03K 17/95, G01D 5/20, G01B 7/02, G01V 3/15, H01F 17/00, H05K 1/16

(54) **INDUKTIVER NÄHERUNGSSENSOR IN INTEGRIERTER BAUWEISE**
INDUCTIVE PROXIMITY SENSOR OF INTEGRATED DESIGN
CAPTEUR DE PROXIMITÉ À INDUCTION PRÉSENTANT UN MODE DE CONSTRUCTION INTÉGRÉ

(43) Veröffentlichungstag der Anmeldung: 28.06.2017
(73) Patentinhaber: Balluff GmbH, 73765 Neuhausen a.d.F. (DE)
(72) Erfinder: KOYUNCU, Ümit, 73760 Ostfildern (DE); GROSS, Jörg, 70619 Stuttgart (DE); PRIBIL, Mario, 70469 Stuttgart (DE)
(74) Vertreter: Jakelski & Althoff Patentanwälte PartG mbB
(86) Internationale Anmeldenummer: PCT/DE2014/100299
(87) Internationale Veröffentlichungsnummer: WO 2016/026476

(56) Entgegenhaltungen:
- EP-A2- 0 581 206
- DE-A1-102006 040 550
- JP-A- S59 190 717
- US-A- 5 461 353
- US-A- 5 863 445
- US-A1- 2002 039 023
- US-A1- 2008 204 118

## Beschreibung

Die Erfindung geht aus von einem Frontend für einen induktiven Näherungssensor bzw. Näherungsschalter sowie einem ein solches Frontend aufweisenden induktiven Näherungssensor bzw. Näherungsschalter, nach der Gattung der unabhängigen Ansprüche.

### Stand der Technik

Auf dem Gebiet der Mess- und Steuertechnik sind induktive Näherungssensoren bzw. Näherungsschalter bekannt, die, im Gegensatz zu mechanisch betätigten, kontaktbehaftet ausgeführten elektrischen Schaltgeräten, berührungsfrei bzw. kontaktlos arbeiten.

Ein solcher Näherungsschalter ist aus DE 10 2006 040 550 A1 bekannt, mit dem sich erfassen lässt, ob sich ein elektrisch leitendes, in der Regel ein metallisches Objekt dem Näherungsschalter hinreichend weit genähert hat. In diesem Fall wird ein zu einer Auswerteschaltung gehörender elektronischer Schalter umgesteuert, wobei bei einem als Schließer ausgeführten Näherungsschalter der vorher nichtleitende elektronische Schalter leitend wird, wohingegen bei einem als Öffner ausgeführten Näherungsschalter der vorher leitende elektronische Schalter nunmehr sperrt.

Nähert sich ein genanntes metallisches Objekt einem solchen induktiven Näherungsschalter hinreichend weit, so steuert ein eine Schwingkreisspule aufweisender Oszillator den genannten elektronischen Schalter in der genannten Weise um. Dabei fließt in der Schwingkreisspule ein Wechselstrom von etwa 200 kHz. Der Wechselstrom baut im Umfeld der Schwingkreisspule ein elektromagnetisches Wechselfeld auf. Wird in dieses Wechselfeld ein genanntes, elektrisch leitendes Objekt ("Target"), zumeist eine Metallfahne, eingebracht, so werden in diesem nach dem Induktionsgesetz Wirbelströme induziert. Dadurch wird dem Stromkreis des Oszillators, zu dem die Schwingkreisspule gehört, elektrische Energie entzogen bzw. dieser bedämpft, wodurch die Schwingungen des Oszillators abklingen bzw. der Oszillator gegebenenfalls sogar ganz aufhört zu schwingen.

Ferner geht aus DE 100 48 290 A1 ein induktiver Näherungssensor hervor, der eine in Form einer strukturierten leitenden Schicht einer Trägerplatine ausgebildete Sensorspule sowie eine Auswerteschaltung umfasst, welche mit der Sensorspule verbunden ist und eine mit Leiterbahnen versehene Schaltungsplatine aufweist. Insbesondere ist bei diesem Sensor vorgesehen, dass die Schaltungsplatine und die Trägerplatine quer zueinander verlaufen und dass mindestens eine Spule durch eine strukturierte, elektrisch leitende Schicht der Schaltungsplatine gebildet ist und in Form von Leiterbahnen in die Schaltungsplatine integriert ist.

Bei diesem bekannten Näherungssensor ist ferner vorgesehen, dass die die Sensorspule tragende Trägerplatine mittels zweier Lötverbindungen mechanisch starr und elektrisch mit der Schaltungsplatine verbunden ist, mittels derer wiederum die Sensorspule mit der Schaltungsplatine elektrisch verbunden ist und gleichzeitig eine mechanische Verbindung von Sensorspule und Schaltungsplatine geschaffen wird. Dadurch bilden die Sensorspule und die Schaltungsplatine eine gemeinsam handhabbare und im weiteren Fertigungsprozess in das Gehäuse als Einheit einsetzbare Einheit.

### Offenbarung der Erfindung

Der Erfindung liegt die Aufgabe zugrunde, ein hier betroffenes Frontend für einen induktiven Näherungsschalter, d.h. eine zum sensierenden Bereich des Näherungssensors hin angeordnete Metallfrontfläche (=Frontend), bzw. einen aus einem solchen Frontend gebildeten Näherungssensor bzw. Näherungsschalter, gegenüber dem Stand der Technik kostengünstiger herstellbar zu machen, jedoch unter Beibehaltung der erforderlichen Genauigkeit bzw. Empfindlichkeit bei der Erfassung genannter sich annähernder Objekte.

Diese Aufgabe wird durch ein Frontend gemäß Anspruch 1, und eine Verfahren gemäß Anspruch 15 gelöst.

Die Erfindung schlägt bei einem hier betroffenen induktiven Näherungssensor bzw. -schalter insbesondere vor, durch Verwendung einer Leiterplattenspule (im Folgenden "Printspule") einen besonders integrierten Aufbau des Frontends zu ermöglichen. Dabei ist insbesondere ein mit dem Frontend bzw. der metallischen Front baulich möglichst identisches, metallisches Beeinflussungselement angeordnet, mittels dessen die durch die metallische Front hervorgerufene Störung der Symmetrie hinsichtlich Position und Materialeigenschaften behoben wird. Das Beeinflussungselement ist bevorzugt in einer entsprechenden Leiterplatte integriert angeordnet und weist eine Öffnung zur Aufnahme wenigstens eines elektrischen Verbindungselementes auf, wobei mittels dieses Verbindungselementes eine Durchkontaktierung der Leiterplatte zu einer elektrischen Anschlussebene, die bevorzugt zur elektrischen Verbindung der Leiterplatte mit einer Steuerelektronik des Näherungssensors dient, erfolgt. In Bezug auf die Leiterplatte mit der erfindungsgemäß integrierten Spulenanordnung ist das Beeinflussungselement bevorzugt entgegengesetzt bzw. gegenüberliegend zum Frontend angeordnet.

Ein erfindungsgemäßes Frontendsystem eines hier betroffenen Näherungssensors bzw. -schalters kann daher vorteilhafterweise als Teil einer entsprechend integrierten Sensorgehäusefront, insbesondere eines Metallgehäuses, ausgebildet sein.

Die Erfindung ermöglicht die Kontaktierung einer hier betroffenen Frontendleiterplatte durch ein genanntes metallisches Beeinflussungselement hindurch bei möglichst geringer Verkleinerung, bzw. sogar unter Maximierung, der Fläche des Beeinflussungselements, um wesentliche Sensoreigenschaften des Beeinflussungselements möglichst zu erhalten und diese Eigenschaften möglichst wenig durch die Kontaktierung zu verändern bzw. zu stören.

Gegenüber anderen an sich bekannten Lösungsansätzen, z.B. der Verwendung von Leiterplatten mit sogenannter "Starrflex"-Anbindung, hat die Erfindung den Vorteil, dass sie wesentlich kostengünstiger herstellbar ist, da sie keine gesonderte Anbringung des Beeinflussungselements erfordert, sowie ein relativ symmetrisches Beeinflussungselement mit einer großen Fläche ermöglicht.

Ein erfindungsgemäßes Frontend für einen induktiven Näherungssensor bzw. - schalter sowie ein ein solches Frontend aufweisender induktiver Näherungssensor bzw. -schalter eignen sich zur berührungsfreien bzw. kontaktlosen Erfassung der Annäherung von metallischen Objekten, insbesondere bei elektrischen und elektronischen Schalt-, Mess-, Steuer- und Regelkreisen, mit den hierin beschriebenen Vorteilen.

### Kurzbeschreibung der Figuren

- Figur 1: zeigt eine schematische Seitenansicht eines erfindungsgemäßen Frontends für einen induktiven Näherungssensor bzw. -schalter.
- Figur 2: zeigt eine schematische Draufsicht eines ersten Ausführungsbeispiels einer erfindungsgemäßen Leiterplatte für ein in Fig. 1 gezeigtes Fronend.
- Figur 3: zeigt eine schematische Draufsicht eines zweiten Ausführungsbeispiels einer erfindungsgemäßen Leiterplatte für ein in Fig. 1 gezeigtes Fronend.
- Figur 4: zeigt eine seitliche Schnittansicht eines ein erfindungsgemäßes Frontend aufweisenden Metallgehäuses, gemäß einem ersten Ausführungsbeispiel.
- Figur 5a, b: zeigen eine Draufsicht (a.) sowie eine seitliche Schnittansicht (b.) eines ein erfindungsgemäßes Frontend aufweisenden Metallgehäuses, gemäß einem zweiten Ausführungsbeispiel.

### Detaillierte Beschreibung der Ausführungsbeispiele

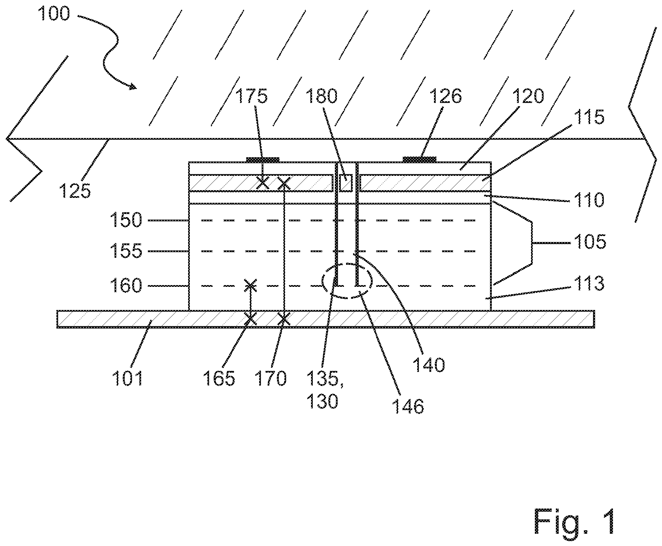

Das in Figur 1 gezeigte Frontend 100 umfasst eine auf einem Metallblech 101 aufgebrachte Leiterplatte 105. Auf der dem Metallblech 101 gegenüberliegenden Seite der Leiterplatte 105 ist ein mit einer ersten Prepreg-Lage 110 abgedecktes, metallisches Beeinflussungselement 115 angeordnet. An der Übergangsseite der Leiterplatte 105 zum Metallblech 101 ist in diesem Ausführungsbeispiel eine zweite Prepreg-Lage 113 angeordnet. Bei dem Werkstoff "Prepreg" handelt es sich bekanntermaßen um ein Glasfasergewebe, welches mit Epoxidharz getränkt ist. Auf dieser Seite der Leiterplatte 105 sind elektrische Kontaktflächen (126, 226 - 229 , 326 - 329) angeordnet, welche zur elektrischen Verbindung des Frontends 100 mit einer elektronischen Baugruppe (125) des Näherungssensors bzw. Näherungsschalters dienen. Es ist anzumerken, dass die Anschlussebene 120 ebenfalls aus Prepreg gebildet sein kann. In diesem Fall sind auf der Anschlussebene 120 genannte elektrische Kontaktflächen angeordnet.

In dem Beeinflussungselement 115 ist eine Aussparung 180 angeordnet, welche mit einem elektrischen Isolator, vorliegend Harz, befüllt ist. Die Aussparung 180 ermöglicht die Anordnung einer nachfolgend beschriebenen Durchkontaktierung mittels wenigstens eines Vias (Via = Vertical Interconnect Access) 135, 140 der Anschlussebene 120 mit der Leiterplatte 105.

Die Leiterplatte 105 ist in dem Ausführungsbeispiel mehrlagig ausgebildet und weist mehrere (vorliegend drei) Leiterbahnebenen 150, 155, 160 auf, wobei in der dritten Leiterbahnebene 160 eine in dieser Darstellung nicht zu sehende Leiterplattenspule ("Printspule") angeordnet ist. Zum Betrieb dieser Printspule sind in einem gestrichelt angedeuteten Bereich 146 der dritten Leiterbahnebene 160 angeordnete bzw. endende Vias 135, 140 mit der Anschlussebene 120 bzw. dort angeordneten Kontaktflächen (bzw. "Lötpads") 126 vorgesehen. Es ist anzumerken, dass jede Leiterbahnebene eine Printspule sein kann. Die Durchkontaktierungen mittels der Vias 130 - 145 verbinden diese Lagen untereinander. Zusätzlich verbinden die Vias auch die elektrischen Kontaktflächen, z.B. gemäß dem Bezugszeichen 126, mit den Leiterbahnebenen bzw. der Leiterplatte 105.

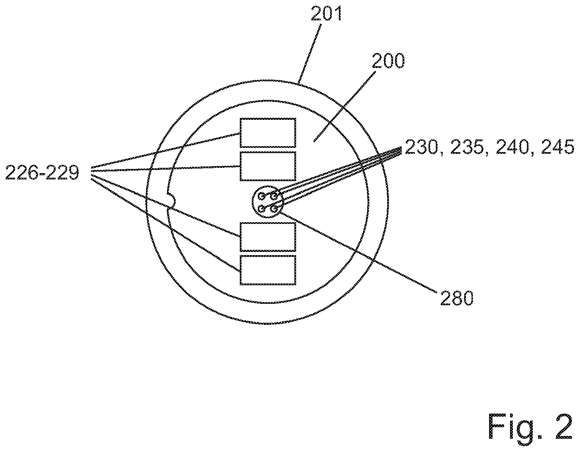

Das Metallblech 101 und das Beeinflussungselement 115 können zusätzlich mit der Printspule und/oder der Anschlussebene 120 über weitere Vias 165, 175 verbunden sein, wobei gemäß Figur 2 wenigstens ein durchgehender Kontakt bzw. Leiter 230, 235, 240, 245 vorgesehen sein kann. Zusätzlich oder alternativ kann vorgesehen sein, das Beeinflussungselement 115 über ein Via 170 mit dem Metallblech101 zu verbinden.

Es ist anzumerken, dass die mit dem Beeinflussungselement 115, den Prepreg-Lagen 110, 113 und der Anschlussebene 120 versehene Leiterplatte 105 eine eigenständig vermarktungsfähige Funktions- bzw. Baueinheit darstellt.

Das in Figur 2 in Draufsicht gezeigte, vorliegend runde Frontend 200 umfasst in dem vorliegenden Ausführungsbeispiel vier elektrische Kontaktflächen (sog. "Lötpads") 226, 227, 228, 229 zur lötverbindenden Aufnahme der elektronischen Baugruppe (125) sowie eine im-Beeinflussungselement angeordnete Aussparung 280, die mit Harz gefüllt ist. Die Aussparung 280 weist in dem Ausführungsbeispiel vier Bereiche für Vias 230, 235, 240, 245, d.h. Kontaktlöcher zur Durchkontaktierung einzelner Metallisierungsebenen, auf. Diese Kontaktlöcher 230 - 245 dienen insbesondere der Durchkontaktierung der (nicht gezeigten) Printspule mit einer in Figur 1 gezeigten Anschlussebene.

Es ist anzumerken, dass die Leiterplatte, je nach Anwendung, auch quadratisch oder reckeckförmig ausgebildet sein kann, da es vorliegend auf ihre äußere Form nicht ankommt.

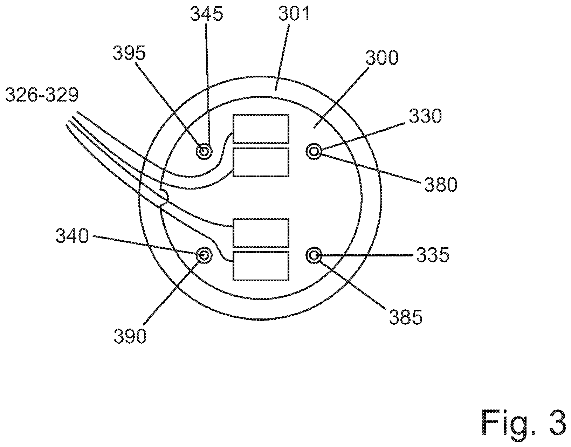

Das in Figur 3 ebenfalls in Draufsicht dargestellte Frontend 300 umfasst in diesem Ausführungsbeispiel wiederum vier elektrische Kontaktflächen 326, 327, 328, 329 zu dem bereits genannten Zweck. Im Unterschied zu Figur 2 sind in dem (in dieser Darstellung nicht zu sehenden) Beeinflussungselement vier Aussparungen 380, 385, 390, 395 angeordnet. Jede dieser Aussparungen 380 - 395 umfasst einen Bereich 330, 335, 340, 345 für einen genannten Via, und zwar wiederum zur genannten Durchkontaktierung der Printspule.

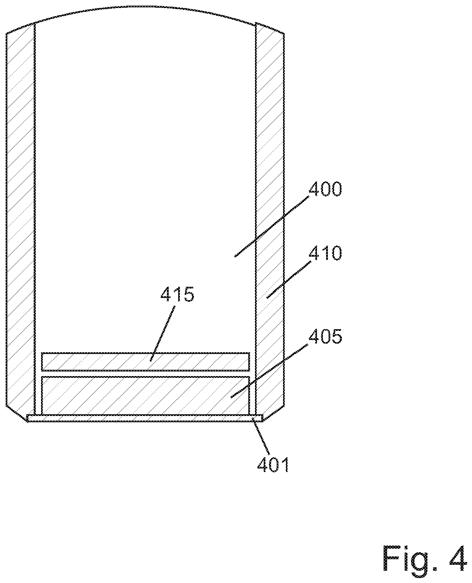

Ein beschriebenes Frontend kann, wie in der Figur 4 gezeigt, in ein Metallgehäuse 410 integriert werden und ist damit gegen jegliche Außeneinflüsse geschützt so dass es z.B. auch in chemisch aggressiven Umgebungen sicher einsetzbar ist. Am unteren Ende des Metallgehäuses 410 gemäß der Ansicht in Figur 4 ist in diesem Ausführungsbeispiel die wiederum auf einem Metallblech 401 im Wesentlichen stoffschlüssig angeordnete Leiterplatte 405 angeordnet. Das Metallblech 401 stellt die genannte Metallfrontfläche eines hier betroffenen Frontends dar. In Figur 4 ist zusätzlich die Anordnung eines bereits beschriebenen Beeinflussungselements 415 schematisch dargestellt.

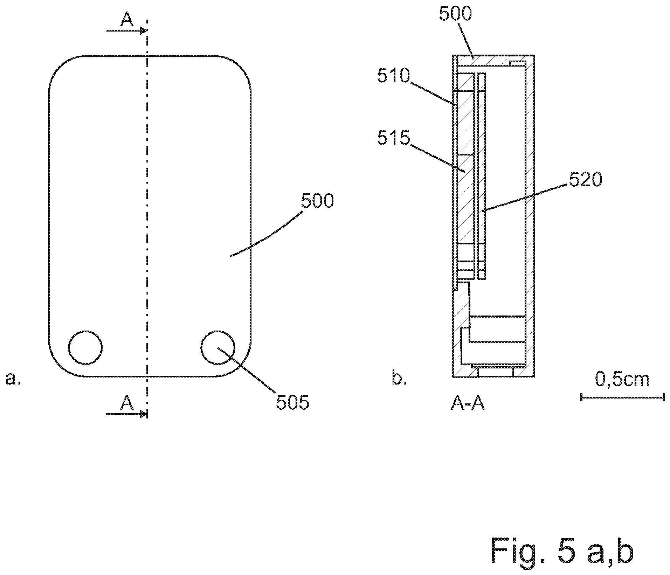

Die Figuren 5a und 5b zeigen ein zweites Ausführungsbeispiel eines in ein Metallgehäuse 500 integrierten Frontends. Die beiden Ausnehmungen bzw. Bohrungen 505 dienen als Montagehilfe. Die in Figur 5b gezeigte Schnittansicht ergibt sich gemäß Figur 5a durch einen Schnitt entlang der Linie A-A. In dem Metallgehäuse 500 ist eine beschriebene Leiterplatte 515 direkt auf einer Frontfläche 510, als Teile des gesamten Gehäuses 500 im Wesentlichen stoffschlüssig angeordnet. In Figur 5b ist zusätzlich ein bereits beschriebenes Beeinflussungselement 520 schematisch eingezeichnet.

Bei der Herstellung einer vorbeschriebenen Leiterplatte 105, 405, 515 wird, ähnlich wie bei der an sich bekannten Technik des "Insulated Metal Substrate" (IMS), ein als genanntes Beeinflussungselement dienendes Metallblech in die Fertigung der Printspule eingebunden. Dieses Blech ist zwischen zwei genannten PrePreg-Lagen angeordnet und ermöglicht die Erstellung einer vorbeschriebenen Durchkontaktierung. Im Gegensatz zum Stand der Technik muss dazu nur ein relativ kleines Loch in das Beeinflussungselement eingebracht (z.B. gebohrt) werden. Im Ergebnis erhält man eine relativ platzsparende Kontaktierung zwischen Printspule und Anschlussebene.

Im Folgenden wird ein bevorzugtes Verfahren zur Herstellung eines erfindungsgemäßen Frontends eines induktiven Näherungssensors bzw. -schalters beschrieben. Zunächst wird eine mehrlagige, und zwar wenigstens zweilagige Printspule auf einer Leiterplatte in an sich bekannter Weise hergestellt. Danach werden die Klebeflächen zwischen der Leiterplatte und dem Beeinflussungselement für den anschließenden Klebevorgang vorbereitet, ggf. einschließlich eines oder mehrerer Reinigungsschritte. Die Klebepartner des Klebevorgangs sind eine beschriebene PrePreg-Lage und ein beschriebenes Metallblech. Danach wird die Leiterplatte mit dem Beeinflussungselement, unter Einbringung z.B. eines PrePregs, unter Druck und Temperatur, zusammenfügt bzw. verpresst. Diese Fertigstellung erfolgt durch einen an sich bekannten Prozess in der Leiterplattenfertigung, wobei die im Beeinflussungselement vorhandene Bohrung mit Harz aufgefüllt wird. Gleichzeitig erfolgt das Verpressen einer weiteren PrePreg-Lage. Anschließend erfolgt das Bohren, Strukturieren und Galvanisieren einschließlich der Durchkontaktierung(en) des Frontends und der letzten Lage, jedoch ohne das Metallblech 101. Schließlich wird das so gebildete Teilpaket mit einer weiteren PrePreg-Lage mit der Metallblech 101 verpresst.

Die Kontaktierungsebene wird entsprechend hergestellt, wobei die Leiterplatte mit dem Beeinflussungselement und einer genannten Prepreg-Lage verpresst wird.

### Bezugszeichenliste

- 101: Metallblech
- 100: Frontend
- 105: Leiterplatte
- 110, 113: Prepreg-Lagen
- 115: Beeinflussungselement
- 120: Anschlussebene
- 125: Elektronische Baugruppe
- 126: Elektrische Kontaktflächen
- 180: Aussparung
- 130 - 145: Vias
- 146: Bereich der dritten Leiterbahnebene
- 150 - 160: Leiterbahnebenen
- 165 - 175: Vias
- 200: Frontend
- 201: Metallblech
- 226 - 229: Elektrische Kontaktflächen
- 280: Aussparung
- 230 - 245: Vias
- 300: Frontend
- 301: Metallblech
- 326 - 329: Elektrische Kontaktflächen
- 380 - 395: Aussparungen
- 330 - 345: Vias
- 400: Frontend
- 405: Leiterplatte
- 401: Metallblech
- 410: Metallgehäuse
- 415: Beeinflussungselement
- 500: Metallgehäuse
- 505: Ausnehmungen
- 510: Frontfläche
- 515: Leiterplatte
- 520: Beeinflussungselement

## Patentansprüche

1. Frontend (100) für einen induktiven Näherungssensor, mit einer metallischen Frontfläche (101), mit einer Spule zur Erfassung eines sich annähernden metallischen Objekts, und mit einer an der metallischen Frontfläche (101) angeordneten Leiterplatte (105), wobei die Spule als Leiterplattenspule (160) ausgebildet ist, wobei ein der metallischen Frontfläche (101) bautechnisch ähnliches, metallisches Beeinflussungselement (115) in die Leiterplatte (105) integriert angeordnet ist, mittels dessen durch die metallische Frontfläche (101) hervorgerufene Störungen der Symmetrie des Frontends (100) in Bezug auf die räumliche Anordnung und die Materialeigenschaften, und damit auf die induktiven Eigenschaften des Frontends (100), behoben werden, und welches wenigstens eine mit einem elektrischen Isolator (113) ausgefüllte Aussparung (180) zur Aufnahme wenigstens eines elektrischen "Vertical Interconnect Access"-Verbindungselementes (135, 140) bereitstellt, wobei mittels des wenigstens einen elektrischen "Vertical Interconnect Access"-Verbindungselementes (135, 140) eine Durchkontaktierung der Leiterplatte (105), durch das metallische Beeinflussungselement (115) hindurch, zu einer elektrischen Anschlussebene (120), die zur elektrischen Verbindung der Leiterplatte (105) mit einer Steuerelektronik (125) des Näherungssensors dient, erfolgt.

2. Frontend nach Anspruch 1, **dadurch gekennzeichnet, dass** das metallische Beeinflussungselement (115) in Form eines als "Insulated Metal Substrate" ausgebildeten Metallblechs (101) an die Leiterplattenspule angebunden ist.

3. Frontend nach Anspruch 2, **dadurch gekennzeichnet, dass** an das Beeinflussungselement (115) wenigstens eine elektrische Isolierlage, insbesondere eine Prepreg-Lage (113), angebunden ist.

4. Frontend nach Anspruch 2, **dadurch gekennzeichnet, dass** das metallische Beeinflussungselement (115) mit wenigstens einer Isolierlage, insbesondere einer Prepreg-Lage (120), abgedeckt ist.

5. Frontend nach einem der vorhergehenden Ansprüche, **dadurch gekennzeichnet, dass** eine elektrische Kontaktfläche (126) mit einer elektronischen Baugruppe (125) elektrisch verbunden ist.

6. Frontend nach Anspruch 5, **dadurch gekennzeichnet, dass** die elektronische Baugruppe an dem Frontend mechanisch fixiert ist.

7. Frontend nach Anspruch 5 oder 6, **dadurch gekennzeichnet, dass** die Anschlussebene (120) wenigstens eine Lötfläche (226) zur lötverbindenden Aufnahme der elektronischen Baugruppe und ggf. weiterer elektronischer Bauelemente aufweist.

8. Frontend nach Anspruch 7, **dadurch gekennzeichnet, dass** als Öffnung wenigstens eine Aussparung (180, 280) mit wenigstens einem Kontaktloch (130, 230) zur Durchkontaktierung der Leiterplattenspule (160) mittels wenigstens eines Vias (135, 140, 145, 230, 235, 240, 245) mit der elektrischen Anschlussebene (120) angeordnet ist.

9. Frontend nach einem der Ansprüche 2 bis 8, **dadurch gekennzeichnet, dass** das Metallblech (101) mit der Leiterplattenspule in der Leiterplatte (105) mittels wenigstens eines die Öffnung bildenden Vias (165) elektrisch verbunden ist.

10. Frontend nach einem der Ansprüche 2 bis 9, **dadurch gekennzeichnet, dass** das Metallblech (101) mit dem Beeinflussungselement (115) über eine Durchkontaktierung mittels wenigstens eines die Öffnung bildenden Vias (170) verbunden ist.

11. Frontend (400) nach einem der vorhergehenden Ansprüche, **dadurch gekennzeichnet, dass** die Leiterplatte (405) mit einem Metallblech (401) eines Metallgehäuses (410) im Wesentlichen stoffschlüssig verbunden ist.

12. Leiterplatte (105, 405, 515) für ein Frontend (100, 200, 300, 400) nach einem der vorhergehenden Ansprüche, **gekennzeichnet durch** ein in oder an der Leiterplatte (105, 405, 515) integriert angeordnetes, der metallischen Frontfläche (101) bautechnisch ähnliches, metallisches Beeinflussungselement (115), welches wenigstens eine Öffnung (180) zur Aufnahme wenigstens eines elektrischen Verbindungselementes (135, 140) bereitstellt, wobei mittels des wenigstens einen elektrischen Verbindungselementes (135, 140) eine Durchkontaktierung der Leiterplatte (105, 405, 515) zu einer elektrischen Anschlussebene (120), die zur elektrischen Verbindung der Leiterplatte (105, 405, 515) mit einer elektronischen Baugruppe (125) des Näherungssensors dient, bereitstellt.

13. Induktiver Näherungssensor, **gekennzeichnet durch** ein Frontend (100, 200, 300, 400) nach einem der Ansprüche 1 bis 11 und/oder eine Leiterplatte (105, 405, 515) nach Anspruch 12.

14. Induktiver Näherungsschalter, **gekennzeichnet durch** ein Frontend nach einem der Ansprüche 1 bis 11 und/oder eine Leiterplatte (105, 405, 515) nach Anspruch 12.

15. Verfahren zur Herstellung eines Frontends (100) für einen induktiven Näherungssensor gemäß Anspruch 1, wobei eine wenigstens zweilagige Printspule (160) auf einer Leiterplatte (105) hergestellt wird, dass die Leiterplatte (105) mit einem Beeinflussungselement (115) gemäß Anspruch 1 verklebt wird, wobei als Klebepartner wenigstens eine erste PrePreg-Lage (110) und ein Metallblech (101) dienen, und dass die Leiterplatte (105) mit dem Beeinflussungselement (115), unter Einbringung der ersten PrePreg-Lage (110), unter Druck und Temperatur, zusammengefügt werden.

16. Verfahren nach Anspruch 15, **dadurch gekennzeichnet, dass** in dem Beeinflussungselement (115) eine Bohrung vorgesehen wird, dass die Bohrung mit Harz aufgefüllt wird, dass eine zweite PrePreg-Lage (113) verpresst wird, dass das Frontend gebohrt, strukturiert und galvanisiert wird, wobei das Frontend (100) und die zweite PrePreg-Lage (113) durchkontaktiert werden, und dass das so gebildete Teilpaket mit einer dritten PrePreg-Lage mit dem Metallblech (101) verpresst wird, wobei die Kontaktierungsebene (120) dadurch hergestellt wird, dass die Leiterplatte (105) mit dem Beeinflussungselement (115) und der dritten PrePreg-Lage (120) verpresst wird.

## Claims

1. Front end (100) for an inductive proximity sensor, having a metal front face (101), having a coil for detecting an approaching metal object and having a circuit board (105) arranged at the metal front face (101), wherein the coil is formed as a circuit board coil (160), wherein a metallic influencing element (115), which is similar in construction to the metal front face (101), is integrally arranged in the circuit board (105), by means of which disruptions of the symmetry with respect to the position and material properties, and thus to the inductive properties of the front end (100), caused by the metal front face (101) are corrected and which provides at least one recess (180) being filled with an electric insulator to receive at least one electrical "vertical interconnect access" connection element (135, 140), wherein a through contact of the circuit board (105), through the metallic influencing element (115), to an electric connection plane (120), which serves to electrically connect the circuit board (105) to a control electronics (125) of the proximity sensor, takes place by means of the at least one electric "vertical interconnect access" connection element (135, 140).

2. Front end according to claim 1, **characterised in that** the metal influencing element (115) is bound to the circuit board coil in the form of a sheet metal (101) formed as an "insulated metal substrate".

3. Front end according to claim 2, **characterised in that** at least one electric insulating layer, in particular a prepreg layer (113), is bound to the influencing element (115).

4. Front end according to claim 2, **characterised in that** the metal influencing element (115) is covered with at least one insulating layer, in particular a prepreg layer (120).

5. Front end according to one of the preceding claims, **characterised in that** an electric contact surface (126) is electrically connected to an electronic assembly group (125).

6. Front end according to claim 5, **characterised in that** the electronic assembly group is mechanically fixed to the front end.

7. Front end according to claim 5 or 6, **characterised in that** the connection plane (120) has at least one soldering surface (226) for solder-connecting receiving of the electronic assembly group and, where appropriate, further electronic components.

8. Front end according to claim 7, **characterised in that**, as the opening, at least one recess (180, 280) is arranged having at least one contact hole (130, 230) for through contacting the circuit plate coil (160) to the electric connection plane (120) by means of at least one via (135, 140, 145, 230, 235, 240 245).

9. Front end according to one of claims 2 to 8, **characterised in that** the metal sheet (101) is electrically connected to the circuit board coil in the circuit board (105) by means of at least one via (165) that forms the opening.

10. Front end according to one of claims 2 to 9, **characterised in that** the metal sheet (101) is connected to the influencing element (115) via through contacting by means of at least one via (170) that forms the opening.

11. Front end (400) according to one of the preceding claims, **characterised in that** the circuit board (405) is substantially firmly bonded to a metal sheet (401) of a metal housing (410).

12. Circuit board (105, 405 515) for a front end (100, 200, 300, 400) according to one of the preceding claims, **characterised by** a metal influencing element (115) which is integrally arranged in or on the circuit board (105, 405, 515) and which is similar in construction to the metal front face (101), said metal influencing element providing an opening (180) to receive at least one electrical connection element (135, 140), wherein a through contact of the circuit board (105, 405, 515) to an electric connection plane (120), which serves to electrically connect the circuit board (105, 405, 515) to an electronic assembly group (125) of the proximity sensor, is provided by means of the at least one electric connection element (135, 140).

13. Inductive proximity sensor, **characterised by** a front end (100, 200, 300, 400) according to one of claims 1 to 11 and/or a circuit board (105, 405, 515) according to claim 13.

14. Inductive proximity switch, **characterised by** a front end according to one of claims 1 to 11 and/or a circuit board (105, 405, 515) according to claim 12.

15. Method for producing a front end (100) for an inductive proximity sensor according to claim 1, wherein a print coil having at least two layers is produced on the circuit board (105), that the circuit board (105) is adhered with an influencing element (115) according to claim 1, wherein the adhesive partners are a prepreg layer and a metal sheet, and that the circuit board (105) is joined to the influencing element (115) under pressure and temperature by introducing the first prepreg layer.

16. Method according to claim 15, **characterised in that** a drilled hole is provided in the influencing element (115), that the drilled hole is filled up with resin, that a second prepeg layer (113) is pressed, that the front end is drilled, structured and galvanised, wherein the front end (100) and the second prepreg layer (113) are through-connected, and that the part packet formed in such a way is pressed to a third prepreg layer by the metal sheet (101), wherein the connection plane (120) is produced **in that** the circuit board (105) is pressed to the influencing element (115) and the third prepreg layer (120).

## Revendications

1. Front end (100) pour un capteur de proximité à induction, comprenant une surface frontale métallique (101), comprenant une bobine permettant de détecter un objet métallique qui s'approche, et comprenant une carte de circuit imprimé (105) disposée sur la surface frontale métallique (101), ladite bobine étant conçue sous la forme d'une bobine sur circuit imprimé (160), un élément influenceur (115) métallique de conception technique similaire à la surface frontale métallique (101) étant intégré dans la carte de circuit imprimé (105) et permettant de remédier aux erreurs de symétrie de l'front end (100), concernant la disposition spatiale et les propriétés matérielles et par conséquent les propriétés inductives de l'front end (100), dues à la surface frontale métallique (101), lequel élément influenceur offre au moins un évidement (180) rempli d'un isolant électrique (113) et servant à recevoir au moins un élément de liaison électrique de type trou de liaison (135, 140), ledit au moins un élément de liaison électrique de type "vertical interconnect access" (135, 140) permettant de réaliser une connexion transversale qui traverse l'élément influenceur métallique (115) et vise à relier la carte de circuit imprimé (105) à un plan de connexion électrique (120) servant à relier par voie électrique la carte de circuit imprimé (105) à une électronique de commande (125) du capteur de proximité.

2. Front end selon la revendication 1, **caractérisée en ce que** l'élément influenceur métallique (115) est lié à la bobine sur circuit imprimé en se trouvant sous la forme d'une plaque métallique (101) de type "insulated metal substrate".

3. Front end selon la revendication 2, **caractérisée en ce qu'**au moins une couche électriquement isolante, notamment une couche de préimprégné (113), est liée à l'élément influenceur (115).

4. Front end selon la revendication 2, **caractérisée en ce que** l'élément influenceur métallique (115) est recouvert d'au moins une couche isolante, notamment une couche de préimprégné (120).

5. Front end selon l'une des revendications précédentes, **caractérisée en ce qu'**une surface de contact électrique (126) est reliée par voie électrique à un module électronique (125).

6. Front end selon la revendication 5, **caractérisée en ce que** le module électronique est fixé mécaniquement à l'front end.

7. Front end selon la revendication 5 ou 6, **caractérisée en ce que** le plan de connexion (120) présente au moins une surface de brasage (226) destinée à recevoir, par le biais d'une liaison par brasage, le module électronique et éventuellement d'autres constituants électroniques.

8. Front end selon la revendication 7, **caractérisée en ce qu'**il est disposé au moins un évidement (180, 280) servant d'ouverture, doté d'au moins un trou de contact (130, 230) servant à effectuer la liaison de la bobine sur circuit imprimé (160) avec le plan de connexion électrique (120) au moyen d'au moins un via (135, 140, 145, 230, 235, 240, 245).

9. Front end selon l'une des revendications 2 à 8, **caractérisée en ce que** la plaque métallique (101) est reliée par voie électrique à la bobine sur circuit imprimé de la carte de circuit imprimé (105) au moyen d'au moins un via (165) formant l'ouverture.

10. Front end selon l'une des revendications 2 à 9, **caractérisée en ce que** la plaque métallique (101) est reliée à l'élément influenceur (115) par le biais d'une connexion transversale au moyen d'au moins un via (170) formant l'ouverture.

11. Front end (400) selon l'une des revendications précédentes, **caractérisée en ce que** la carte de circuit imprimé (405) est reliée à une plaque métallique (401) d'un boîtier métallique (410) essentiellement par liaison de matière.

12. Carte de circuit imprimé (105, 405, 515) pour une front end (100, 200, 300, 400) selon l'une des revendications précédentes, **caractérisée par** un élément influenceur (115) métallique, de conception technique similaire à la surface frontale métallique (101), qui est intégré dans ou sur la carte de circuit imprimé (105, 405, 515) et qui offre au moins une ouverture (180) servant à recevoir au moins un élément de liaison électrique (135, 140), ledit au moins un élément de liaison électrique (135, 140) permettant de réaliser un connexion transversale qui vise à relier la carte de circuit imprimé (105, 405, 515) à un plan de connexion électrique (120) servant à relier par voie électrique la carte de circuit imprimé (105, 405, 515) à un module électronique (125) du capteur de proximité.

13. Capteur de proximité à induction, **caractérisé par** une front end (100, 200, 300, 400) selon l'une des revendications 1 à 11 et/ou une carte de circuit imprimé (105, 405, 515) selon la revendication 12.

14. Détecteur de proximité à induction, **caractérisé par** une front end selon l'une des revendications 1 à 11 et/ou une carte de circuit imprimé (105, 405, 515) selon la revendication 12.

15. Procédé de production d'une front end (100) pour un capteur de proximité à induction selon la revendication 1, dans lequel il est produit une bobine imprimée (160) au moins à deux couches sur une carte de circuit imprimé (105), et la carte de circuit imprimé (105) est collée à un élément influenceur (115) selon la revendication 1, une première couche de préimprégné (110) et une plaque métallique (101) entrant en jeu dans le cadre du collage avec un adhésif, et la carte de circuit imprimé (105) et l'élément influenceur (115) sont assemblés l'un à l'autre grâce à la mise en place de la première couche de préimprégné (110), sous l'action de la pression et de la température.

16. Procédé selon la revendication 15, **caractérisé en ce qu'**il est prévu un alésage dans l'élément influenceur (115), **en ce que** l'alésage est rempli de résine, **en ce qu'**une deuxième couche de préimprégné (113) est réalisée par compression, **en ce que** l'front end est percée, structurée et galvanisée, ladite front end (100) et ladite deuxième couche de préimprégné (113) étant mises en contact par un trou de liaison, et **en ce que** le paquet partiel ainsi formé reçoit la compression d'une troisième couche de préimprégné sur la plaque métallique (101), la production dudit plan de mise en contact (120) résultant de la compression de l'élément influenceur (115) et de la troisième couche de préimprégné (120) sur la carte de circuit imprimé (105).
